# EUROPÄISCHE PATENTSCHRIFT

(11) **EP 1 159 327 B1**
(45) Veröffentlichungstag und Bekanntmachung des Hinweises auf die Patenterteilung: **12.04.2006**
(21) Anmeldenummer: 99958059.0
(22) Anmeldetag: 17.11.1999
(51) Int. Cl.: C08G 61/02, C08G 61/12

(54) **VERFAHREN ZUR HERSTELLUNG VON DERIVATEN DES POLYARYLENVINYLEN**
METHOD OF PRODUCING DERIVATIVES OF POLYARYLENE VINYLENE
PROCEDE POUR PREPARER DES DERIVES DE VINYLENE DE POLYARYLENE

(30) Priorität: 15.12.1998 DE 19857661
(43) Veröffentlichungstag der Anmeldung: 05.12.2001
(73) Patentinhaber: Covion Organic Semiconductors GmbH, 65926 Frankfurt (DE)
(72) Erfinder: VANDERZANDE, Dirk, B-3740 Bilzen (BE); GELAN, Joanes, B-3600 Genk (BE); VAN BREEMEN, Albert, NL-5628 XA Eindhoven (NL); VAN DER BORGHT, Michael, B-2300 Turnhout (BE); ISSARIS, Anna, B-3511 Kuringen (BE); LUTSEN, Laurence, 59210 Coudekerque-Branche (FR); DE KOK, Margreet, NL-5628 XA Eindhoven (NL); KREUDER, Willi, D-55126 Mainz (DE)
(74) Vertreter: Luderschmidt, Schüler & Partner GbR
(86) Internationale Anmeldenummer: PCT/EP1999/008830
(87) Internationale Veröffentlichungsnummer: WO 2000/035987

(56) Entgegenhaltungen:
- EP-A- 0 705 857
- WO-A-91/15534
- US-A- 4 766 198
- ISSARIS A ET AL: "Polymerization of a p-quinodimethane derivative to a precursor of poly(p-phenylene vinylene)--indications for a free radical mechanism" POLYMER,GB,ELSEVIER SCIENCE PUBLISHERS B.V, Bd. 38, Nr. 10, 1. Mai 1997 (1997-05-01), Seiten 2571-2574, XP004059760 ISSN: 0032-3861
- VANDERZANDE D J ET AL: "A GENERAL APPROACH TO PRECURSORS FOR POLY(ARYLENE VINYLENE) DERIVATIVES: MECHANISM, SCOPE AND MODIFICATIONS" MACROMOLECULAR SYMPOSIA,DE,WILEY VCH, WEINHEIM, Bd. 125, 1. Januar 1998 (1998-01-01), Seiten 189-203, XP000738960 ISSN: 1022-1360

## Beschreibung

Die vorliegende Erfindung betrifft ein Verfahren zur Herstellung von Polyarylenvinylenen. Diese konjugierten Polymere sind unter anderem für Elektrolumineszenzanwendungen geeignet.

Es besteht ein hoher industrieller Bedarf an großflächigen Festkörper-Lichtquellen für eine Reihe von Anwendungen, überwiegend im Bereich von Anzeigeelementen, der Bildschirmtechnologie und der Beleuchtungstechnik. Die an diese Lichtquellen gestellten Anforderungen können zur Zeit von keiner der bestehenden Technologien völlig befriedigend gelöst werden.

Als Alternative zu herkömmlichen Anzeige- und Beleuchtungselementen, wie Glühlampen, Gasentladungslampen und nicht selbstleuchtenden Flüssigkristallanzeigeelementen, sind bereits seit einiger Zeit Elektrolumineszenz (EL)-materialien und -vorrichtungen, wie lichtemittierende Dioden (LED), in Gebrauch.

Neben anorganischen Elektrolumineszenzmaterialien und -vorrichtungen sind seit etwa 30 Jahren auch niedermolekulare, organische Elektrolumineszenzmaterialien und -vorrichtungen bekannt (siehe z.B. US-A-3,172,862). Bis vor kurzem waren aber solche Vorrichtungen in ihrer praktischen Anwendbarkeit stark eingeschränkt.

In der EP-A-0,423,283 und der EP-A-0,443,861 sind Elektrolumineszenzvorrichtungen beschrieben, die einen Film aus einem konjugierten Polymer als lichtemittierende Schicht (Halbleiterschicht) enthalten. Solche Vorrichtungen bieten zahlreiche Vorteile, wie die Möglichkeit, großflächige, flexible Displays einfach und kostengünstig herzustellen. Im Gegensatz zu Flüssigkristalldisplays sind Elektrolumineszenzdisplays selbstleuchtend und benötigen daher keine zusätzliche rückwärtige Beleuchtungsquelle.
Eine typische Vorrichtung nach EP-A-0,423,283 besteht aus einer lichtemittierenden Schicht in Form eines dünnen, dichten Polymerfilms (Halbleiterschicht), der mindestens ein konjugiertes Polymer enthält. Eine erste Kontaktschicht steht in Kontakt mit einer ersten Oberfläche, eine zweite Kontaktschicht mit einer weiteren Oberfläche der Halbleiterschicht. Der Polymerfilm der Halbleiterschicht hat eine genügend geringe Konzentration von extrinsischen Ladungsträgern, so daß beim Anlegen eines elektrischen Feldes zwischen den beiden Kontaktschichten Ladungsträger in die Halbleiterschicht eingebracht werden, wobei die eine Kontaktschicht positiv gegenüber der anderen wird, und die Halbleiterschicht Strahlung aussendet. Die in solchen Vorrichtungen verwendeten Polymere sind konjugiert. Unter konjugiertem Polymer versteht man ein Polymer, das ein delokalisiertes Elektronensystem entlang der Hauptkette besitzt. Das delokalisierte Elektronensystem verleiht dem Polymer Halbleitereigenschaften und gibt ihm die Möglichkeit, positive und/oder negative Ladungsträger mit hoher Mobilität zu transportieren.

In EP-A-0,423,283 und der EP-A-0,443,861 ist als polymeres Material für die lichtemittierende Schicht Poly(p-phenylenvinylen) beschrieben, welches mit Alkyl-, Alkoxy-, Halogen- oder Nitrosubstituenten am aromatischen Kern modifiziert werden kann. Derartige Polymere sind seither in einer großen Anzahl von Studien untersucht worden und gerade dialkoxysubstituierte PPVs sind schon sehr weit in Richtung Anwendungsreife hin optimiert worden (vgl. z. B. J. Salbeck, Ber. Bunsenges. Phys. Chem. 1996, 100, 1667). Allerdings kann die Entwicklung derartiger Polymere keinesfalls als abgeschlossen betrachtet werden. So sind unter anderem immer noch Verbesserungen hinsichtlich der Lebensdauer, der Beständigkeit und auch der erzielbaren Farbe nötig. Die am weitesten entwickelte obengenannte Polymerklasse, Dialkoxy-PPV, ist nämlich nur zur Emission orangeroten Lichtes geeignet.

EP-A-0,705,857 beschreibt die Herstellung von α,ω-ungesättigten Polymeren unter verwendung von Bosen und Löse mitteln, wie z.B. Alkoholen.

Die vorstehenden Polymeren sind nur in unbefriedigender Ausbeute zugänglich. Typische Polymerisationen ergeben typischerweise Ausbeuten von nur 70 % der Theorie, oft sogar nur weniger als 50 %.

Es besteht daher ein großer Bedarf an wirtschaftlichen Verfahren zur Herstellung von Polyarylenvinylenen. Gegenstand der vorliegenden Erfindung ist ein Verfahren zur Herstellung von Polymeren der Formel (I) 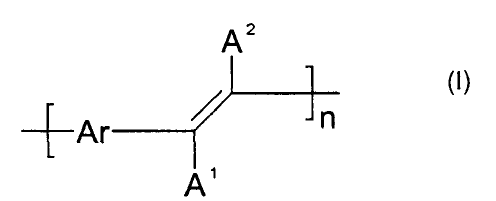 worin Ar die Bedeutung Ar¹ und/oder Ar² annehmen kann und
- Ar¹: ein aromatisches Ringsystem mit 4 bis 20 Kohlenstoffatomen, der gegebenenfalls ein oder mehrfach mit C₁-C₂₀-Alkyl, C₁-C₂₀-Alkoxy, C₃-C₂₀₋verzweigtem Alkyl, Phenyl oder Benzyl-Resten substituiert sein kann, und gegebenenfalls bis zu 4 Heteroatome aus der Gruppe Sauerstoff, Schwefel und Stickstoff im aromatischen Ringsystem enthalten kann, bedeutet,
- Ar²: für einen Rest der Formel 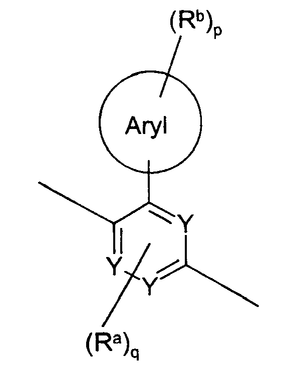 steht bei dem
- Y: gleich oder verschieden, CH oder N;
- Aryl: eine Arylgruppe mit 4 bis 14 C-Atomen;
- R^{a}, R^{b}: gleich oder verschieden eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, CN, F, Cl oder eine Arylgruppe mit 4 bis 14 C-Atome, die durch einen oder mehrere, nicht aromatische Reste R^{a} substituiert sein kann;
- R¹,R²,R³,R⁴: gleich oder verschieden aliphatische oder aromatische Kohlenwasserstoffreste mit 1 bis 20 C-Atomen oder auch H bedeuten
- A⁻: ein einfach geladenes Anion oder dessen Äquivalent;
- q: 0, 1 oder 2;
- p: 1, 2, 3, 4 oder 5 bedeutet,
- A¹, A²: gleich oder verschieden sind und Wasserstoff oder einen C₁ bis C₂₀₋kohlenstoffhaltige Gruppe bedeuten
- n: 5 bis 50000, vorzugsweise 10 bis 20000, insbesondere 10 bis 15000
umfassend die Maßnahmen
a) Umsetzung von mindestens einem Monomeren der Formel (II) 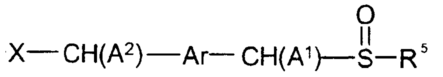 worin
   - Ar: die unter Formel (I) genannte Bedeutung hat,
   - X: eine Abgangsgruppe, und
   - R⁵: ein unverzweigtes Alkyl mit 1 bis 20 Kohlenstoffatomen, ein verzweigtes Alkyl mit 3 bis 20 Kohlenstoffatomen, ein cyclisches Alkyl, wie Cyclohexyl, oder ein C₁-C₄-alkylsubstituiertes cyclisches Alkyl, wie Cyclohexylmethyl, Phenyl oder Benzyl, die gegebenenfalls substituiert sein können, und/oder Heteroatome, wie O, N, Si enthalten können, bedeutet,
   mit einer Base in Gegenwart eines Alkohols als Lösungsmittels zur Verbindung der Formel (III) 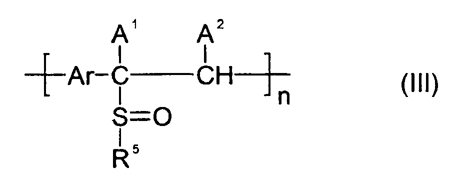 worin Ar, A¹, A², R⁵ und n die vorstehende Bedeutung haben,
b) Erwärmen der Verbindung der Formel (III) unter Ausbildung einer polymeren Verbindung der Formel (I),
dadurch gekennzeichnet, daß in Maßnahme a) als Alkohol sekundäre und tertiäre Alkohole mit mindestens 4 Kohlenstoffatomen eingesetzt werden.

Bevorzugt steht der Rest X für eine Abgangsgruppe wie Halogen, -O-Tosylat, -O-Mesylat oder -O-trifluoracetat.

Bevorzugt werden mit dem erfindungsgemäßen Verfahren Verbindungen der Formel (I) in denen Ar für die Struktureinheit 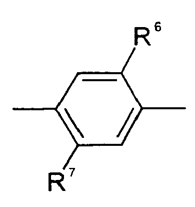 worin
- R⁶, R⁷: gleich oder verschieden sind, und Wasserstoff, ein unverzweigter Alkyl- oder Alkoxy-Rest mit 1 bis 20 Kohlenstoffatomen, ein verzweigter Alkyl- oder Alkoxy-Rest mit 1 bis 20 Kohlenstoffatomen, Phenyl oder Benzyl, wobei die vorstehend genannten Reste gegebenenfalls substituiert sein können, Halogen, insbesondere Chlor, Brom oder Fluor, Cyano, Nitro, oder einen Ester mit 1 bis 20 Kohlenstoffatomen steht.
Insbesondere bevorzugt sind Verbindungen der Formel (I) in denen Ar die vorstehende Bedeutung hat und R⁶ und R⁷ unabhängig voneinander für die Reste unverzweigter Alkoxy-Rest mit 1 bis 20 Kohlenstoffatomen, ein verzweigter Alkoxy-Rest mit 1 bis 20 Kohlenstoffatomen, Phenyl oder Benzyl, wobei die vorstehend genannten Reste gegebenenfalls substituiert sein können, Halogen, insbesondere Chlor, Brom oder Fluor, Cyano, Nitro, oder einen Ester mit 1 bis 20 Kohlenstoffatomen steht.
Weiterhin bevorzugt sind Verbindungen der Formel (I) in denen R⁶ und R⁷ unabhängig voneinander für die Reste unverzweigter Alkoxy-Rest mit 1 bis 10 Kohlenstoffatomen, ein verzweigter Alkoxy-Rest mit 3 bis 20 Kohlenstoffatomen, Phenyl, der durch ein oder mehrere, verzweigte oder unverzweigte Alkyl- oder Alkoxygruppen mit bis zu 20 C-Atomen substituiert sein kann, steht.
Bevorzugt steht R⁵ für n-, i-,s-, t-Butyl, i-Pentyl, Octyl, 3,6,9,-trioxadecyl, 2-Hydroxyethyl, 2-Chlorethyl, besonders bevorzugt n-Butyl und n-Octyl.

Gleichermaßen bevorzugt werden mit dem erfindungsgemäßen Verfahren Verbindungen der Formel (I) in denen Ar für die Struktureinheit 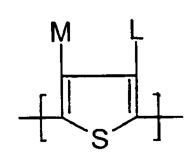 worin
- M, L: gleich oder verschieden sind, und Wasserstoff, ein unverzweigter Alkyl- oder Alkoxy-Rest mit 1 bis 16 Kohlenstoffatomen, ein verzweigter Alkyl- oder Alkoxy-Rest mit 3 bis 16 Kohlenstoffatomen, Phenyl oder Benzyl, wobei die
vorstehend genannten Reste gegebenenfalls substituiert sein können, Halogen, insbesondere Chlor, Brom oder Fluor, Cyano, Nitro, oder einen Ester mit 1 bis 16 Kohlenstoffatomen steht, oder M und L gemeinsam eine Brücke mit mindestens 4 Brückengliedern, die auch ein oder mehrere Heteroatome, insbesondere Sauerstoff und/oder Schwefel, enthalten können.

Die Herstellung der monomeren Verbindungen der Formel (II) ist in der deutschen Patentanmeldung 19840943.5 beschrieben.

Bei den erfindungsgemäß eingesetzten sekundären und/oder tertiären Alkoholen handelt es sich insbesondere um Alkohole mit mindestens 4 Kohlenstoffatomen deren Siedepunkt bei Normaldruck < 300°C ist. Besonderes bevorzugt werden s-Butanol, 2-Pentanol, 3-Pentanol, 3-Methyl-2-butanol, 2-Methyl-2-butanol, 2,3-Butandiol, 2-Octanol, 3-Octanol, 2-Methyl-2-hexanol, 2-Methyl-3-hexanol, 5-Methyl-2-hexanol, Cyclohexanol, Regio- und Stereo-Isomere des Methylcyclohexanols, 1-Methylcyclohexanol, t-Butanol, 2-Phenyl-2-propanol wobei häufig auch Gemische vorteilhaft sind, insbesondere dann, wenn wie bei t-Butanol, das reine Lösungsmittel bei Raumtemperatur als Feststoff vorliegt.

Die Maßnahme b) kann einerseits ohne Lösungsmittel, z. B. in einem gegossenen und getrockneten Film, oder aber in einer Lösung, d.h. in Gegenwart eines Lösungsmittel ausgeführt werden. Die Art dieses Lösungsmittels kann gewählt werden aus der Gruppe von inerten Lösungsmitteln wie aromatische aromatische Lösungsmittel, wie Chlorbenzol, Xylole oder Toluol. Als besonders geeignet hat sich Toluol erwiesen. Eine weitere Gruppe von inerten Lösungsmitteln sind Ether, z.B. t-Butylmethylether, Di-n-butylether, oder cyclische Ether, wie Dioxan, Tetrahydropyran, Tetrahydrofuran, Anisol, die besonders geeignet sind. Auch sind Ketone (Aceton, Butanon, Cyclopentanon, Cyclohexanon), Sulfone (DMSO), Nitrile (Acetonitril, Benzonitril), Ester (Butylacetat, Methylbenzoat), Lactone (Butyrolacton), Amide (DMF, N-Methylformamid) und Lactame (NMP, N-Methylcaprolactam) geeignet. Lösungsmittel mit verschiedenen Funktionalitäten, wie Cyanessigsäureethylester oder 2-Methoxyethylacetat können auch vorteilhaft benutzt werden. Weiterhin bevorzugte sind die unter Maßnahme a) aufgeführten speziellen Alkohole. Selbst polar-protische Lösungsmittel, wie n-Butanol, n-Propanol, Ethanol, Methanol oder Wasser lassen sich vorteilhaft einsetzen.

Häufig lassen sich auch Gemische der oben genannten Lösungsmittel vorteilhaft verwenden, wobei homogen mischbare Lösungsmittel besonders bevorzugt sind. In einer wirtschaftlich besonders attraktiven Ausführungsform wird die Maßnahme b) in situ ausgeführt, d. h. im selben Lösungsmittel in dem auch Maßnahme a) durchgeführt wird, wobei gegebenenfalls die Konzentration durch Einengen oder Verdünnen verändert werden kann.

Der Druck während beider Reaktionsschritte ist von untergeordneter Bedeutung und richtet sich vor allem nach dem Dampfdruck des Lösungsmittels bei der gewählten Temperatur.

Bei Maßnahme a) und b) ist durch inertisieren mit einem Inertgas, wie Stickstoff oder Argon auf den Ausschluß von Sauerstoff zu achten.

Für die Maßnahme a) geeignete Basen sind anorganische oder organische Basen. Geeignete anorganische Basen sind NaOH, KOH und LiOH. Geeignete organische Basen sind sterisch gehinderte, wie Lithiumdiisopropylamid (LDA), Natriumtrimethylsilanoat, Bis(trimethylsilyl)kaliumamid, insbesondere jedoch Alkali-tert. Butanolate, wie KOtBu, NaOtBu und die Na- oder K-Alkoholate, der als Lösungsmittel verwendeten Alkohole. Das kommerziell verfügbare NaOtBu liefert besonders gute Ergebnisse.

Die eingesetzte Menge an Base kann stark variieren, wobei pro Mol Monomer der Formel (II) bis zu 8 Äquivalente an Base eingesetzt werden können. Bevorzugt werden jedoch pro Mol Monomer der Formel (II) 0,85 bis 1,6 Äquivalente Base, insbesondere 0,95 bis 1,05 Äquivalente, eingesetzt. Dieses Verhältnis erweist sich als besonders vorteilhaft, da eine übermäßige Menge an Base zum Teil nur mit erheblichem Aufwand aus dem Endprodukt entfernt werden kann.

Reaktionstemperaturen und -zeiten für die Maßnahme b) lassen sich über einen weiten Bereich variieren, wobei generell bei einer kürzeren Reaktionszeit eine höhere Temperatur zu wählen ist. Bei Temperaturen bis +200°C sind die Reaktionszeiten zwischen 5 min und 48 h zu wählen. Bevorzugt sind Temperaturen größer 60°C, besonders bevorzugt wird bei der Siedetemperatur des verwendeten Lösungsmittels eliminiert.

Mit Hilfe des erfindungsgemäßen Verfahrens werden die Ausbeuten an Verbindungen der Formel (I) bezogen auf eingesetztes Monomer der Formel (II) beträchtlich gesteigert und betragen mehr als 80%, vorzugsweise sogar mehr als 85% der Theorie.

### Beispiele

Alle Reaktionen wurden unter Stickstoff durchgeführt.

Molekulargewichte wurden durch Gelpermeationschromatographie (GPC) in THF gegen Polystyrolstandards (PS) bestimmt.

### Beispiel 1

Polymerisation von 4-(Octylsulfinylmethyl)-3-methoxy-6-(3,7-dimethyloctyloxy)benzylchlorid und 4-(Octylsulfinylmethyl)-6-methoxy-3-(3,7-dimethyloctyloxy)benzylchlorid zu Precursor-Polymeren
2 mmol des Monomeren in 14 ml s-Butanol wurden durch einstündiges Einleiten von Stickstoff entgast. Eine Lösung oder Aufschlämmung von Natrium t-butanolat (0.25 g, 2.6 mmol) in 6 ml s-Butanol wurde auf einmal zugegeben. Eine Stunde später wurde die Reaktionsmischung unter kräftigem Rühren in 200 ml Eiswasser getropft. Die Mischung wurde mit 1 n Salzsäure neutralisiert und dreimal mit je 100 ml Chloroform extrahiert. Nach Aufkonzentrierung im Vakuum wird das Rohprodukt in 12.5 g Chloroform aufgenommen und die Lösung in 125 g eines Fällmittels, d.h. Mischung aus n-Hexan und Diethylether (1:1, w/w), getropft. Das ausgefallene Precursorpolymer wird abgesaugt, mit dem Fällmittel nachgewaschen und im Vakuum getrocknet.
Die Ausbeute war praktisch quantitativ .
GPC: M̅_{w} = 307.000 , Polydispersität 2.1

Konversion des Precursorpolymeren:
Poly[2-methoxy-5-(3,7-dimethyloctyloxy)phenylen-1,4-vinylen-co-5-methoxy-2-(3,7-dimethyloctyloxy)phenylen-1,4-vinylen]

Das Precursorpolymer wurde 3 h in 50 ml Toluol (110°C) zum Rückfluß erhitzt. Nach Ausfällen in 300 ml Methanol werden 3.6 g des konjugierten Polymeren erhalten. Ausbeute 98 % bezogen auf eingesetztes Monomer in Beispiel 1.
GPC: M̅_{w} = 560.000 , Polydispersität 3.8

### Vergleichsbeispiel 1

### 2 g (4,6 mmol) einer 1:1 Mischung der Isomeren

α-Chlor- α'-n-butylsulfinyl-2-(3,7-dimethyloctyloxy)-5-methoxy-*p*-xylol und α-Chlor- α'-n-butylsulfinyl-2-methoxy-5-(3,7-dimethyloctyloxy)-*p*-xylol wurden in 25 ml NMP gelöst und die Lösung während einer Stunde mit Stickstoff gespült. 0.468 g (4.87 mmol, 1.05 eq.) NaO*t*Bu wurden in 20 ml *s*-BuOH gelöst und die Lösung während einer Stunde mit Stickstoff gespült. Die NaO*t*Bu Lösung wurde bei 23°C zur Lösung des Monomeren zugesetzt. Eine Stunde danach wurde die Mischung in 100 ml H₂O gegeben und mit 0.1 n HCl neutralisiert. Die wäßrige Phase wurde mit 100 ml Chloroform extrahiert. Die organische Phase wurde über MgSO₄ getrocknet und im Vakuum eingeengt: 0.36 g des rohen intensiv gelben Precursorpolymeren wurden erhalten.

Konversion des Precursorpolymeren
Durch Erhitzen in 50 ml siedendem Toluol (110°C, 3 h) und Ausfällen in 300 ml Methanol wurden 0.28 g (14 %) des konjugierten Polymeren erhalten.
GPC: M̅_{w} = 654.000 , PD = 5.3.

### Beispiel 2

### 7 g (0.0162 mol) einer 1:1 Mischung der Isomeren

α-Chlor- α'-n-butylsulfinyl-2-(3,7-dimethyloctyloxy)-5-methoxy-*p*-xylol und α-Chlor- α'-n-butylsulfinyl-2-methoxy-5-(3,7-dimethyloctyloxy)-*p*-xylol wurden in 60 ml s-BuOH in einem 250 ml Dreihalskolben gelöst und mit Stickstoff gespült. Eine ebenso sauerstoffreie Lösung von 2.04 g NaOtBu (0.0214 mol) in 60 ml s-BuOH wurde bei 23°C zur Lösung zugesetzt, und nach einer Stunde die Lösung in 300 ml H₂O eingetropft . Nach Neutralisieren mit 0.1 n HCl wurde die wäßrige Phase mit 200 ml Chloroform extrahiert. Die org. Phase wurde über MgSO₄ , im Vakuum konzentriert, wobei 6 g (0,0151 mmol = 93 %) des Precursor-Polymeren erhalten wurden.
GPC: Mₚ = 2.18 10⁵ ; M̅_{w} = 3.07 10⁵; M̅ₙ = 1.47 10⁵; PD = 2.08.

Konversion des Precursorpolymeren
Nach 3 h Behandeln in 50 ml siedendem Toluol (110°C) und Ausfällen in 300 ml Methanol wurden 3.9 g (0,0135 mol = 83 %) des konjugierten Polymers erhalten.
GPC: Mp = 4.42 10⁵ ; M̅_{w} = 5.60 10⁵ ; M̅ₙ = 1.47 10⁵ ; D = 3.80.

### Beispiel 3-5 und Vergleichsbeispiele 2-11

### Polymerisation von α-Chlor-α'-octylsulfinyl-p-xylol

2 mmol des Monomeren wurden in 14 ml eines Lösungsmittels gelöst, und durch einstündiges Einleiten von Stickstoff entgast. Eine ebenso bei 30°C entgaste Lösung oder Aufschlämmung von Natrium *t*-butanolat (0.25 g, 2.6 mmol) in 6 ml desselben Lösungsmittels wurde bei 30°C auf einmal zugegeben. Eine Stunde später wurde die Reaktionsmischung unter kräftigem Rühren in 200 ml Eiswasser getropft. Die Mischung wurde mit 1 n Salzsäure neutralisiert und dreimal mit je 100 ml Chloroform extrahiert. Nach Aufkonzentrierung im Vakuum wird das Rohprodukt in 12.5 g Chloroform aufgenommen und die Lösung in 125 g eines Fällmittels, d.h. Mischung aus n-Hexan und Diethylether (1:1, w/w), getropft. Das ausgefallene Precursorpolymer wird abgesaugt, mit dem Fällmittel nachgewaschen und im Vakuum getrocknet.

| Beispiel | Lösungsmittel | Ausbeute Precursor-Polymer (%) | Nichtpolymere Produkte (%) | M̅_{w} (x 10³) | PD |
|---|---|---|---|---|---|
| Vergl. 2 | CH₂Cl₂ | 76 | 12 | 350 | 2.4 |
| Vergl. 3 | THF | 81 | 12 | 735 | 3.9 |
| Vergl. 4 | DMSO | 49 | 41 | 475 | 4.0 |
| Vergl. 5 | MMF | 28 | 69 | 780 | 3.0 |
| Beisp. 3 | s-BuOH | 88 | 8 | 238 | 2.0 |

| Beispiel | Lösungsmittel | Ausbeute Precursor -Polymer (%) | Nichtpolymere Produkte (%) | M̅_{w}(x 10³) | PD |
|---|---|---|---|---|---|
| Vergl. 6 | MeOH | 0 | 100 | -- | -- |
| Vergl. 7 | EtOH | 11 | 87 | 104 | 1.7 |
| Vergl. 8 | *n*-PrOH | 30 | 62 | 118 | 1.7 |
| Vergl. 9 | *n*-BuOH | 28 | 65 | 104 | 1.7 |
| Vergl. 10 | *n*-PentOH | 42 | 56 | 84 | 1.7 |
| Vergl. 11 | *i*-PrOH | 21 | 78 | 437 | 2.3 |
| Bsp 4 | *t*-BuOH | 89 | 4 | 225 | 2.1 |
| Bsp 5 | s-PentOH | 89 | 5 | 296 | 2.4 |

| | | | | | |
|---|---|---|---|---|---|
| MMF = Monomethylformamid | | | | | |

### Beispiele 6-12

Polymerisation von verschiedenen α-Chlor-α'-alkylsulfinyl-ρ*-*xylol in *s*-Butanol unter Bedingungen gemäß Beispiel 3

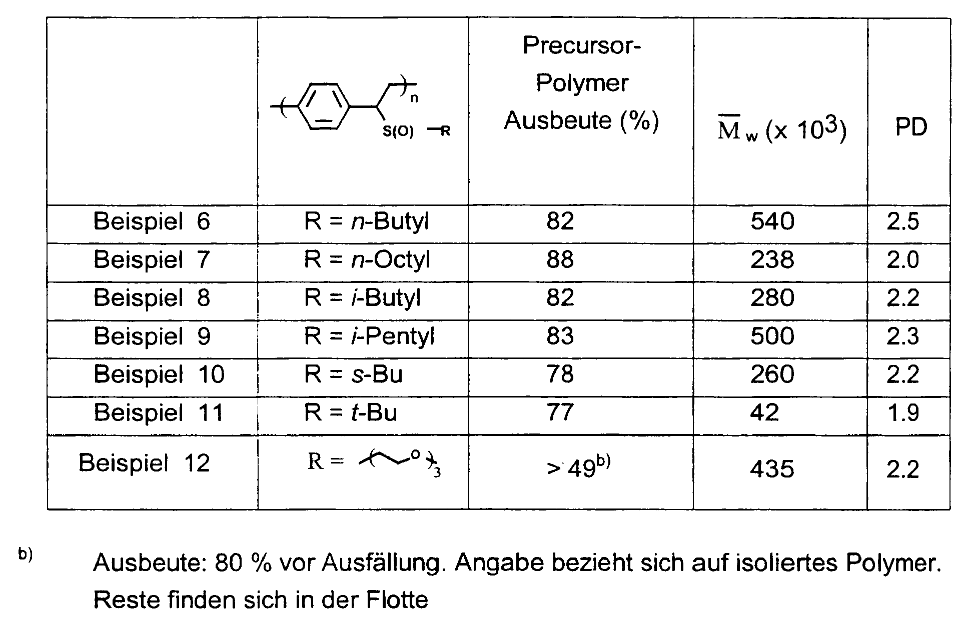

### Beispiel 13-14 und Vergleichsbeispiel 12-15

### Polymerisation von α-Chlor-α '-n-butylsulfinyl-2,5-dimethyl-p-xylol unter Bedingungen gemäß Beispiel 3

| | Lösungsmittel | T (°C) | Äq. Base | M̅_{w}(x 10³) | PD | Ausbeute (%) |
|---|---|---|---|---|---|---|
| Vergl. 12 | Monomethylformamid (MMF) | 20 | 1.3 | 620 | 2.9 | 25 |
| Vergl. 13 | MMF : CH₂Cl₂ (3:2) | 20 | 1.3 | 632 | 2.6 | 25 |
| Vergl. 14 | Formamid : THF (3:1) | 20 | 1.3 | 390 | 2.4 | 20 |
| Vergl. 15 | NMP | -10 | 1.3 | 192 | 1.9 | 55 |
| Bsp.13 | *t*-Butanol | 20 | 1.3 | 177 | 1.9 | 85 |
| Bsp. 14 | s-Butanol | 20 | 1.3 | 773 | 2.6 | 90 |

### Beispiel 15 und Vergleichsbeispiel 16-17

### Polymerisation von α-Chlor-α'-n-butylsulfinyl-2,5-dimethoxy-p-xylol unter Bedingungen gemäß Beispiel 3

| | Lösungsmittel | T (°C) | äq. Base | M̅_{w} (x 10³) | PD | Ausbeute (%) |
|---|---|---|---|---|---|---|
| Vergl. 16 | MMF | 20 | 1.3 | 267 | 1,8 | 35 |
| Vergl. 17 | NMP | -10 | 1.3 | 90 | 1.7 | 30 |
| Bsp.15 | s-Butanol | 20 | 1.3 | 133 | 1.9 | 75 |

### Beispiel 16

### Polymerisation von α-Chlor-α'-n-butylsulfinyl-2,5-chlor-p-xylol unter Bedingungen gemäß Beispiel 3

Bei T =20°C wurden 65 % des entsprechenden Precursorpolymeren mit 1,3 Basenäquivalenten erhalten, das in der GPC ein Mw von 678.000 g/mol und eine PD von 3,3 aufwies.

### Beispiel 17

### Polymerisation von α-Chlor-α'-butylsulfinyl-p-xylol

10.2 g (0.106 mol) NaO*t*Bu gelöst in 240 ml s-Butanol wurde in einem Guß zu einer mechanisch gerührten Lösung von 20 g (0.082 mol) a-Chlor-a'-butylsulfinyl-*p*-xylol in 570 ml s-Butanol gegossen. Nach weiteren 60 min Rühren wird die Mischung in 1,5 I Eiswasser eingegossen, mit 1 n HCl neutralisiert und mit CHCl₃ extrahiert. Dieses wurde i.V. abdestilliert, der Rückstand in CHCl₃ aufgenommen und in Diethylether ausgefällt.
Der im Vakuum getrocknete, weiße Feststoff ergibt 14.7 g (86 %) Precursor-Polymer.

Ein Lagerversuch im Tiefkühlschrank bei -18°C ergab keine Verfärbung, keine Gewichtsveränderung und keine Geruchsbelästigung.

## Patentansprüche

1. Verfahren zur Herstellung von Polymeren der Formel (I) 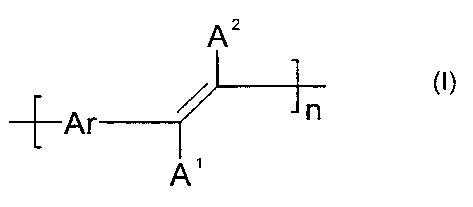 worin Ar die Bedeutung Ar¹ und/oder Ar² annehmen kann und
Ar¹ ein aromatisches Ringsystem mit 4 bis 20 Kohlenstoffatomen, der gegebenenfalls ein oder mehrfach mit C₁-C₂₀-Alkyl, C₁-C₂₀-Alkoxy, C₃-C₂₀₋verzweigtem Alkyl, Phenyl oder Benzyl-Resten substituiert sein kann, und gegebenenfalls bis zu 4 Heteroatome aus der Gruppe Sauerstoff, Schwefel und Stickstoff im aromatischen Ringsystem enthalten kann, bedeutet,
Ar² für einen Rest der Formel 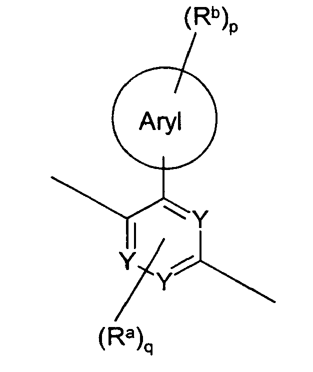 steht bei dem
Y gleich oder verschieden, CH oder N;
Aryl eine Arylgruppe mit 4 bis 14 C-Atomen;
R^{a}, R^{b} gleich oder verschieden eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, CN, F, Cl oder eine Arylgruppe mit 4 bis 14 C-Atome, die durch einen oder mehrere, nicht aromatische Reste R^{a} substituiert sein kann;
R¹,R²,R³,R⁴ gleich oder verschieden aliphatische oder aromatische Kohlenwasserstoffreste mit 1 bis 20 C-Atomen oder auch H bedeuten
A⁻ ein einfach geladenes Anion oder dessen Äquivalent;
q 0, 1 oder 2;
p 1, 2, 3, 4 oder 5 bedeutet,
A¹, A² gleich oder verschieden sind und Wasserstoff oder einen C₁ bis C₂₀₋kohlenstoffhaltige Gruppe bedeuten
n 5 bis 50000 bedeutet
umfassend die Maßnahmen
a) Umsetzung von mindestens einem Monomeren der Formel (II) 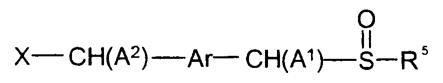 worin
Ar die unter Formel (I) genannte Bedeutung hat,
X eine Abgangsgruppe, und
R⁵ ein unverzweigtes Alkyl mit 1 bis 20 Kohlenstoffatomen, ein verzweigtes Alkyl mit 3 bis 20 Kohlenstoffatomen, ein cyclisches Alkyl oder ein C₁₋C₄-alkylsubstituiertes cyclisches Alkyl, das gegebenenfalls substituiert sein kann, und/oder Heteroatome, wie O, N, Si enthalten kann, bedeutet,
mit einer Base in Gegenwart eines Alkohols als Lösungsmittels zur Verbindung der Formel (III) 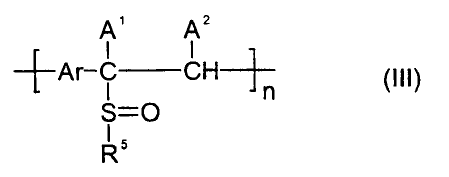 worin Ar, A¹, A², R⁵ und n die vorstehende Bedeutung haben,
b) Erwärmen der Verbindung der Formel (III) unter Ausbildung einer polymeren Verbindung der Formel (I)
**dadurch gekennzeichnet, daß** in Maßnahme a) als Alkohol sekundäre und tertiäre Alkohole mit mindestens 4 Kohlenstoffatomen eingesetzt werden.

2. Verfahren gemäß Anspruch 1, **dadurch gekennzeichnet, daß** es sich bei den Verbindungen der Formel (I) um solche handelt, bei denen Ar für die Struktureinheit 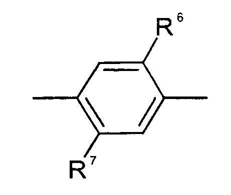 worin
R⁶, R⁷ gleich oder verschieden sind, und Wasserstoff, ein unverzweigter Alkyl- oder Alkoxy-Rest mit 1 bis 20 Kohlenstoffatomen, ein verzweigter Alkyl- oder Alkoxy-Rest mit 1 bis 20 Kohlenstoffatomen, Phenyl oder Benzyl, wobei die vorstehend genannten Reste gegebenenfalls substituiert sein können, Halogen, insbesondere Chlor, Brom oder Fluor, Cyano, Nitro, oder einen Ester mit 1 bis 20 Kohlenstoffatomen steht.

3. Verfahren gemäß Anspruch 1, **dadurch gekennzeichnet, daß** es sich bei den Verbindungen der Formel (I) um solche handelt, bei denen Ar für die Struktureinheit 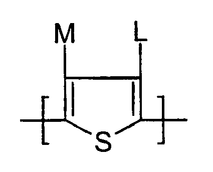 worin
M, L gleich oder verschieden sind, und Wasserstoff, ein unverzweigter Alkyl- oder Alkoxy-Rest mit 1 bis 16 Kohlenstoffatomen, ein verzweigter Alkyl- oder Alkoxy-Rest mit 3 bis 16 Kohlenstoffatomen, Phenyl oder Benzyl, wobei die vorstehend genannten Reste gegebenenfalls substituiert sein können, Halogen, insbesondere Chlor, Brom oder Fluor, Cyano, Nitro, oder einen Ester mit 1 bis 16 Kohlenstoffatomen steht, oder M und L gemeinsam eine Brücke mit mindestens 4 Brückengliedern, die auch ein oder mehrere Heteroatome, insbesondere Sauerstoff und/oder Schwefel, enthalten können.

4. Verfahren gemäß einem der Ansprüche 1 bis 3, **dadurch gekennzeichnet, daß** ein sekundärer und/oder tertiärer Alkohol eingesetzt wird, dessen Siedepunkt bei Normaldruck < 300°C ist.

5. Verfahren gemäß Anspruch 4, **dadurch gekennzeichnet, daß** als Alkohol s-Butanol, 2-Pentanol, 3-Pentanol, 3-Methyl-2-butanol, 2-Methyl-2-butanol, 2,3-Butandiol, 2-Octanol, 3-Octanol, 2-Methyl-2-hexanol, 2-Methyl-3-hexanol, 5-Methyl-2-hexanol, Cyclohexanol, Regio- und Stereo-Isomere des Methylcyclohexanols, 1-Methylcyclohexanol, t-Butanol, 2-Phenyl-2-propanol oder Gemische derselben eingesetzt werden.

## Claims

1. A process for the preparation of polymers of the formula (I) 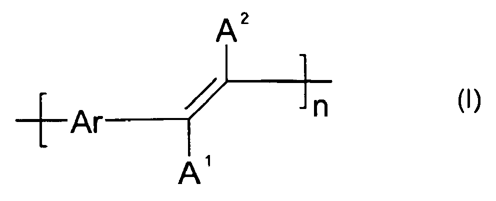 in which Ar can adopt the meaning Ar¹ and/or Ar² and
Ar¹ is an aromatic ring system having 4 to 20 carbon atoms, which may, if desired, be monosubstituted or polysubstituted by C₁-C₂₀-alkyl, C₁-C₂₀-alkoxy, C₃-C₂₀₋branched alkyl, phenyl or benzyl radicals and which may contain up to 4 heteroatoms from the group consisting of oxygen, sulfur and nitrogen in the aromatic ring system,
Ar² is a radical of the formula 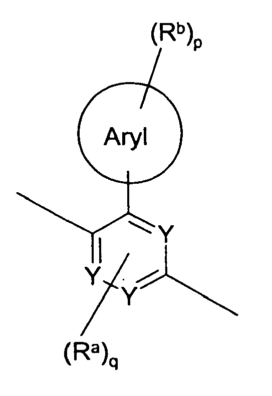
in which
Y are identical or different and are CH or N;
Aryl is an aryl group having 4 to 14 carbon atoms;
R^{a} and R^{b} are identical or different and are a straight-chain or branched or cyclic alkyl or alkoxy group having 1 to 20 carbon atoms, in which one or more non-adjacent CH₂ groups may be replaced by -O-, -S-, -CO-, -COO-, -O-CO-, -NR¹-, -(NR²R³)⁺-A⁻, or -CONR⁴- and in which one or more H atoms may be replaced by F, or are CN, F, Cl or an aryl group having 4 to 14 carbon atoms, which may be substituted by one or more non-aromatic radicals R^{a};
R¹, R², R³ and R⁴ are identical or different and are aliphatic or aromatic hydrocarbon radicals having 1 to 20 carbon atoms or are alternatively H;
A⁻ is a singly charged anion or an equivalent thereof;
q is 0, 1 or 2;
p is 1, 2, 3, 4 or 5;
A¹ and A² are identical or different and are hydrogen or a C₁- to C₂₀-carbon-containing group; and
n is from 5 to 50,000;
comprising the following measures:
a) reaction of at least one monomer of the formula (II) 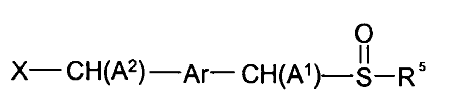 in which
Ar is as defined under the formula (I),
X is a leaving group, and
R⁵ is unbranched alkyl having 1 to 20 carbon atoms, branched alkyl having 3 to 20 carbon atoms, cyclic alkyl or C₁-C₄-alkyl-substituted cyclic alkyl, which may be substituted or unsubstituted and/or contain heteroatoms, such as O, N and Si,
with a base in the presence of an alcohol as solvent, to give the compound of the formula (III) 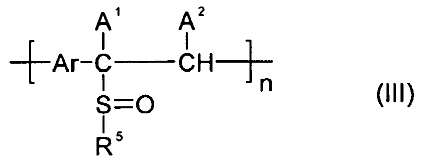 in which Ar, A¹, A², R⁵ and n are as defined above,
b) warming of the compound of the formula (III) with formation of a polymeric compound of the formula (I),
which comprises employing a secondary or tertiary alcohol having at least 4 carbon atoms as the alcohol in measure a).

2. The process as claimed in claim 1, wherein the compounds of the formula (I) are those in which Ar is the structural unit 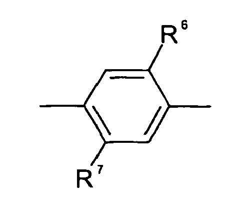 in which
R⁶ and R⁷ are identical or different and are hydrogen, an unbranched alkyl or alkoxy radical having 1 to 20 carbon atoms, a branched alkyl or alkoxy radical having 1 to 20 carbon atoms, phenyl or benzyl, where the abovementioned radicals may be unsubstituted or substituted, halogen, in particular chlorine, bromine or fluorine, cyano, nitro, or an ester having 1 to 20 carbon atoms.

3. The process as claimed in claim 1, wherein the compounds of the formula (I) are those in which Ar is the structural unit 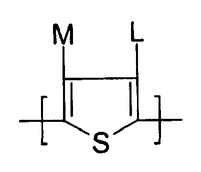 in which
M and L are identical or different and are hydrogen, an unbranched alkyl or alkoxy radical having 1 to 16 carbon atoms, a branched alkyl or alkoxy radical having 3 to 16 carbon atoms, phenyl or benzyl, where the abovementioned radicals may be unsubstituted or substituted, halogen, in particular chlorine, bromine or fluorine, cyano, nitro, or an ester having 1 to 16 carbon atoms, or M and L together are a bridge having at least 4 bridge members, which may also contain one or more heteroatoms, in particular oxygen and/or sulfur.

4. The process as claimed in claim 1 to 3, wherein a secondary and/or tertiary alcohol is employed whose boiling point at atmospheric pressure is < 300°C.

5. The process as claimed in claim 4, wherein the alcohol employed is s-butanol, 2-pentanol, 3-pentanol, 3-methyl-2-butanol, 2-methyl-2-butanol, 2,3-butanediol, 2-octanol, 3-octanol, 2-methyl-2-hexanol, 2-methyl-3-hexanol, 5-methyl-2-hexanol, cyclohexanol, regio- and stereoisomers of methylcyclohexanol, 1-methylcyclohexanol, t-butanol or 2-phenyl-2-propanol, or a mixture thereof.

## Revendications

1. Procédé pour préparation de polymères de la formule (I) 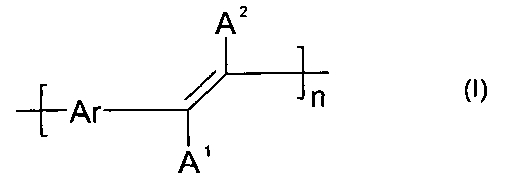 où Ar est Ar¹ ou Ar² et
Ar¹ est un système d'anneau aromatique ayant 4 à 20 atomes de carbone, qui est de manière optionnelle monosubstitué ou polysubstitué par alkyle-C₁₋C₂₀, alkoxy-C₁-C₂₀, alkyle ramifié C₃-C₂₀, radicaux de phényle ou benzyle et qui contient de plus de manière optionnelle jusqu'à 4 hétéroatomes sélectionnés d'un groupe consistant en oxygène, soufre et nitrogène dans le système d'anneau aromatique, est un radical de la formule
Ar² pour un reste de la formule 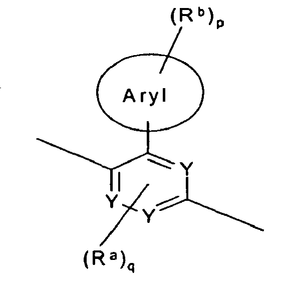
où
Y sont identiques ou différents et sont CH ou N;
Aryle est un groupe aryle ayant 4 à 14 atomes de carbone;
R^{a} et R^{b} sont identiques ou différents et sont un groupe alkyle ou alkoxy à chaîne linéaire ou ramifiée ou cyclique ayant 1 à 20 atomes de carbone dans lequel un ou plusieurs groupes non-adjacents CH₂ est remplacé de manière optionnelle par -O-, -S-,-CO-, -COO-, -O-CO, -NR¹-, -(NR² R³)⁺-A⁻, ou -CONR⁴- et où un ou plusieurs atomes H est remplacé de manière optionnelle par F ou sont CN, F, Cl ou un groupe aryle ayant 4 à 14 atomes de carbone, qui est substitué de manière optionnelle par un ou plusieurs radicaux non aromatiques R^{a};
R¹, R², R³ et R⁴ sont identiques ou différents et sont des radicaux hydrocarbone aliphatiques et aromatiques ayant 1 à 20 atomes de carbone ou sont alternativement H;
A⁻ est un anion chargé individuellement ou un équivalent de celui-ci ;
q est 0, 1, ou 2;
p est 1, 2, 3, 4 ou 5;
A¹ et A² sont identiques ou différents et sont hydrogène ou un groupe contenant carbone C₁ à C₂₀; et
n est à partir de 5 à 50.000
qui comprend les étapes de
a) réagir au moins un monomère de la formule (II) 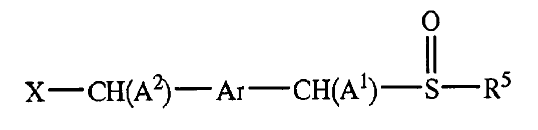 où
Ar qui a le sens mentionné dans la formule (I)
X est un groupe partant, et
R⁵ est alkyle non ramifié ayant 1 à 20 atomes de carbone, alkyle ramifié ayant 3 à 20 atomes de carbone, alkyle cyclique ou alkyle cyclique substitué -alkyle - C₁-C₄, qui est substitué ou non substitué de manière optionnelle et/ou contient des hétéroatomes, comme O, N et Si,
qui est détrempé dans un alcool comme un solvant, avec une base, pour donner le composé de la formule (III) 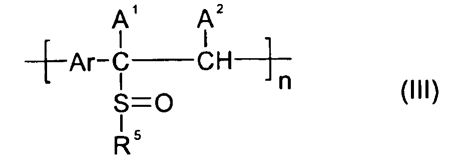 où Ar, Ar¹, Ar², R⁵ et n sont comme définis ci-dessus,
b) chauffer le composé de la formule (III) avec la formation d'un composé polymère de la formule (I),
**caractérisé en ce que** l'utilisation d'un alcool secondaire ou tertiaire ayant au moins 4 atomes de carbone comme l'alcool dans l'étape a).

2. Procédé selon la revendication 1, **caractérisé en ce que** Ar dans les composés de la formule (I) est une unité structurale 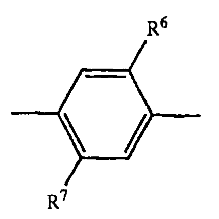 où
R⁶ et R⁷ sont identiques ou différents et sont hydrogène, un alkyle non ramifié ou radical alkoxy ayant 1 à 20 atomes de carbone, un alkyle ramifié ou radical alkoxy ayant 1 à 20 atomes de carbone, phényle dessus sont non-substitués ou substitués, halogène, cyano, nitro, ou un ester ayant 1 à 20 atomes de carbone.

3. Procédé selon la revendication 1, **caractérisé en ce que** Ar dans les composés de la formule (I) est une unité structurale 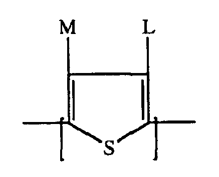 où
M et L sont identiques ou différents et sont hydrogène, un alkyle non ramifié ou radical alkoxy ayant 1 à 16 atomes de carbone, un alkyle ramifié ou radical alkoxy ayant 3 à 16 atomes de carbone, phényle ou benzyle, où les radicaux mentionnés ci-dessus sont non-substitués ou substitués, halogène, cyano, nitro, ou un ester ayant 1 à 16 atomes de carbone, ou M et L ensemble sont un pont ayant au moins 4 éléments de pont, qui contiennent de manière optionnelle un ou plusieurs hétéroatomes, spécialement oxygène et/ou soufre.

4. Procédé selon l'une des revendications 1 à 3, **caractérisé en ce que** est utilisé un alcool secondaire et/ou tertiaire dont le point d'ébullition à la pression atmosphérique est < 300°C.

5. Procédé selon la revendication 4, **caractérisé en ce que** l'alcool est s-butanol,2-pentanol, 3- pentanol, 3-méthyle-2-butanol, 2-méthyle-2-butanol, 2,3-butanediol, 2-octanol, 3-octanol, 2-méthyle-2-hexanol, 2-méthyle-3-hexanol, 5-méthyle-2-hexanol, cyclohexanol, régio-et stéréoisomères de méthylcyclohexanol, 1-méthylcyclohexanol, t-butanol ou 2-phényle-2-propanol ou un mélange de ceux-ci.
